# EUROPEAN PATENT APPLICATION

(11) **EP 4 779 682 A1**
(43) Date of publication of application: **22.07.2026**
(21) Application number: 24864415.5
(22) Date of filing: 22.08.2024
(51) Int. Cl.: H01L 21/67, B65G 49/07

(54) **WAFER TRANSFER METHOD, APPARATUS AND SYSTEM**

(30) Priority: 12.09.2023 CN 202311178873
(71) Applicant: Jiangsu Qiwei Semiconductor Equipment Co., Ltd., Nantong, Jiangsu 226299 (CN); PNC Process Systems Co., Ltd., Shanghai 200241 (CN)
(72) Inventor: LU, Saihao, Nantong, Jiangsu 226299 (CN); XU, Ming, Nantong, Jiangsu 226299 (CN); SHEN, Yilin, Shanghai 200241 (CN); JIANG, Yuan, Shanghai 200241 (CN)
(74) Representative: Stöckeler, Ferdinand
(86) International application number: PCT/CN2024/113884
(87) International publication number: WO 2025/055692

(57) **Abstract**

A wafer transfer method, apparatus and system, comprising: acquiring a wafer pick-and-place requirement of a wafer processing position B; executing the wafer pick-and-place requirement of a wafer processing position Bx, and acquiring the times Ty, Tz respectively required for completing processing of the first two wafer processing positions By, Bz, wherein Ty<Tz; determining whether the times Ty, Tz meet a preset condition; and if the preset condition is met, first executing the wafer pick-and-place requirement of the wafer processing position By; and otherwise, returning to a wafer exchange position A to execute the wafer pick-and-place requirement. The wafer transfer method of the present invention performs determination by calculating the times required for wafer processing positions, the round-trip time of a wafer transfer mechanism, and the like, so as to execute a subsequent wafer pick-and-place action, thereby implementing the function of planning a path in advance. The present invention can be applied to point-to-multipoint and multipoint-to-multipoint wafer transfer modes, ensuring that more wafer transfer requirements can be processed per unit time, and improving the wafer transfer efficiency.

## Description

This application claims the priority to Chinese Patent Application No.202311178873.7, titled "WAFER TRANSFER METHOD, APPARATUS AND SYSTEM", filed on September 12, 2023 with the China National Intellectual Property Administration, which is incorporated herein by reference in its entirety.

### FIELD

The present disclosure relates to the technical field of wafer processing devices, and in particular to a wafer transfer method, apparatus and system.

### BACKGROUND

Currently, in the field of single-wafer transfer, a wafer pick-and-place structure with dual-clamping structures is generally adopted in a wafer transfer mechanism. One clamping structure picks a to-be-processed wafer at a wafer exchange station A and place the to-be-processed wafer at a wafer processing station B; and the other picks a processed wafer at the wafer processing station B and place the processed wafer at the wafer exchange station A. The wafer transfer mechanism with dual-clamping structures can realize a wafer transfer requirement efficiently in a point-to-point transfer mode. However, with a rapid development of the wafer transfer mode, a transfer requirement of one point to multiple points or multiple points to multiple points has become a mainstream. There is a situation where a wafer processing station Bx and a wafer processing station By complete the processing within similar time and simultaneously wait for the wafer transfer mechanism to execute wafer pick-and-place operations. In this case, the processing efficiency is decreased due to poor transfer efficiency. Therefore, it is difficult for the current structure to achieve the transfer efficiency required by the latest transfer mode, and it is urgent to develop a new type of wafer pick-and-place mechanism to realize a one-to-multiple transfer or a multiple-to-multiple transfer requirement.

### SUMMARY

A wafer transfer method, apparatus and system are provided in the present disclosure to improve wafer transfer efficiency.

In order to achieve the above objective, the following technical solutions are provided according to the present disclosure.

In a first aspect, a wafer transfer method is provided, and the wafer transfer method includes the following steps:
obtaining a wafer pick-and-place request for a wafer processing station B;
executing a wafer pick-and-place request for a wafer processing station Bx, and obtaining a duration Ty required for a wafer processing station By to complete a processing task and a duration Tz required for a wafer processing station Bz to complete a processing task, where the processing task performed by the wafer processing station By and the processing task performed by the wafer processing station Bz are completed first, and Ty<Tz;
determining whether the durations Ty, Tz and a wafer transfer duration meet a predetermined condition;
in response to determining that the predetermined condition is met, moving to the wafer processing station By to execute a wafer pick-and-place request; and
in response to determining that the predetermined condition is not met, returning to a wafer exchange station A to execute a wafer pick-and-place request.

In an embodiment, the predetermined condition in the wafer transfer method described above includes: Ty≤t1, where
t1 represents a duration required for a wafer transfer apparatus to move between positions of the wafer processing station B.

In an embodiment, the predetermined condition in the wafer transfer method described above includes: Ty>t1, and Ty≤T+2t, where
t1 represents a duration required for a wafer transfer apparatus to move between positions of the wafer processing station B;
t represents a round-trip duration required for the wafer transfer apparatus to move from a wafer exchange station A to all the positions of the wafer processing station B ; and
T represents a duration required for the wafer transfer apparatus to execute one wafer pick-and-place operation after reaching a position.

In an embodiment, the predetermined condition in the wafer transfer method described above includes: Ty>t1, Ty<T+2t, and Tz≥Ty+T+2t, where
t1 represents a duration required for a wafer transfer apparatus to move between positions of the wafer processing station B;
t represents a round-trip duration required for the wafer transfer apparatus to move from a wafer exchange station A to all the positions of the wafer processing station B; and
T represents a duration required for the wafer transfer apparatus to execute one wafer pick-and-place operation after reaching a position.

In an embodiment, the predetermined condition in the wafer transfer method described above includes: Ty>t1, Ty<T+2t, Tz<Ty+T+2t, and T_{not wait} ≥T_{wait} , where
t1 represents a duration required for a wafer transfer apparatus to move between positions of the wafer processing station B;
t represents a round-trip duration required for the wafer transfer apparatus to move from a wafer exchange station A to all the positions of the wafer processing station B;
T represents a duration required for the wafer transfer apparatus to execute one wafer pick-and-place operation after reaching a position;
T_{not wait} represents a processing waiting time when the wafer pick-and-place request for the wafer processing station By is not waited, T_{not wait} =T+2t-Ty; and
T_{wait} represents a processing waiting time when the wafer pick-and-place request for the wafer processing station By is waited, and T_{wait} =Ty+2T+2t-Tz.

In a second aspect, a wafer transfer apparatus is provided according to the present disclosure to move according to any of the wafer transfer method described above, where the wafer transfer apparatus includes: a wafer transfer mechanism; a multi-axis robot; and a wafer pick-and-place mechanism. The wafer transfer mechanism is configured to move between a wafer exchange station and multiple wafer processing stations. The multi-axis robot is arranged on the wafer transfer mechanism to regulate a pick-and-place angle of the wafer pick-and-place mechanism. The wafer pick-and-place mechanism is arranged on the multi-axis robot to execute wafer pick-and-place.

In an embodiment, the wafer pick-and-place mechanism in the wafer transfer apparatus described above includes multiple pick-and-place clamping structures, and the multiple the pick-and-place clamping structures are arranged one above another.

In an embodiment, the wafer pick-and-place mechanism in the wafer transfer apparatus described above includes four pick-and-place clamping structures: a first pick-and-place clamping structure, a second pick-and-place clamping structure, a third pick-and-place clamping structure and a fourth pick-and-place clamping structure. The first pick-and-place clamping structure and the third pick-and-place clamping structure form a group, one for picking a wafer and the other for placing a wafer. The second pick-and-place clamping structure and the fourth pick-and-place clamping structure form a group, one for picking a wafer and the other for placing a wafer.

In a third aspect, a wafer transfer system is provided according to the present disclosure, and the wafer transfer system includes: a wafer exchange station; multiple wafer processing stations; a wafer transfer apparatus; and a controller. The controller performs the following steps:
obtaining a wafer pick-and-place request for a wafer processing station B;
executing a wafer pick-and-place request for a wafer processing station Bx, and obtaining a duration Ty required for a wafer processing station By to complete a processing task and a duration Tz required for a wafer processing station Bz to complete a processing task, where the processing task performed by the wafer processing station By and the processing task performed by the wafer processing station Bz are completed first, and Ty<Tz;
determining whether the durations Ty and Tz meet a predetermined condition;
in response to determining that the predetermined condition is met, moving to the wafer processing station By to execute a wafer pick-and-place request; and
in response to determining that the predetermined condition is not met, returning to a wafer exchange station A to execute a wafer pick-and-place request.

In an embodiment, the controller in the wafer transfer system described above is integrated on the wafer transfer apparatus.

It can be seen from the above technical solution that in the wafer transfer method according to the present disclosure, the required duration of the wafer processing station and the round-trip duration of the wafer transfer mechanism are calculated, and subsequent wafer pick-and-place operations are executed based on the calculation, so that route planning in advance is realized. The wafer transfer method is applicable to wafer transfer in one-to-multiple mode and multiple-to-multiple mode, ensuring that more wafer transfer requests can be processed per unit time and improving the wafer transfer efficiency.

### BRIEF DESCRIPTION OF THE DRAWINGS

Hereinafter drawings to be applied in embodiments of the present disclosure or in conventional technology are briefly described, in order to clarify illustration of technical solutions according to embodiments of the present disclosure or in conventional technology. Apparently, the drawings in the following descriptions are only some examples or embodiments of the present disclosure, and other drawings may be obtained by those skilled in the art based on the provided drawings without exerting creative efforts. In addition, the present disclosure may be further applied to other similar scenarios based on the drawings. The same reference numerals in the drawings represent the same structures or operations unless it is obvious from the language context or otherwise stated.
FIG. 1 is a schematic diagram of a transfer route of a single-wafer transfer mechanism according to the conventional technology;
FIG. 2 is a schematic diagram of a wafer transfer method according to the conventional technology;
FIG. 3 is a flowchart of a wafer transfer method according to the present disclosure;
FIG. 4 is a schematic diagram of a wafer transfer route according to the present disclosure;
FIG. 5 is a flowchart of a wafer transfer method according to the present disclosure;
FIG. 6 is a schematic diagram of a wafer transfer method according to the present disclosure;
FIG. 7 is a front view of a wafer transfer apparatus according to the present disclosure; and
FIG. 8 is a side view of a wafer transfer apparatus according to the present disclosure.

In the figure, 100 represents a wafer transfer apparatus, 110 represents a wafer transfer mechanism, 120 represents a multi-axis robot, 130 represents a wafer pick-and-place mechanism, 131 represents a first pick-and-place clamping structure, 132 represents a second pick-and-place clamping structure, 133 represents a third pick-and-place clamping structure, and 134 represents a fourth pick-and-place clamping structure.

### DETAILED DESCRIPTION

Hereinafter, the present disclosure is further explained in detail in conjunction with the drawings and embodiments. It should be understood that the embodiments described here are used to explain the present disclosure, but not to limit the present disclosure. The described embodiments are only some of the embodiments of the present disclosure, not all of them. All other embodiments obtained by those skilled in the art based on the embodiments of the present disclosure without any creative work fall within the protection scope of the present disclosure.

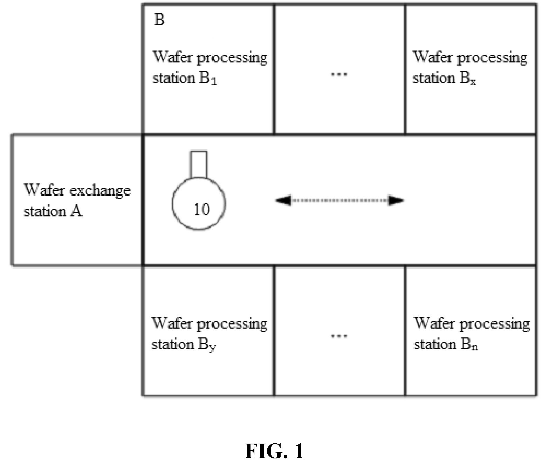

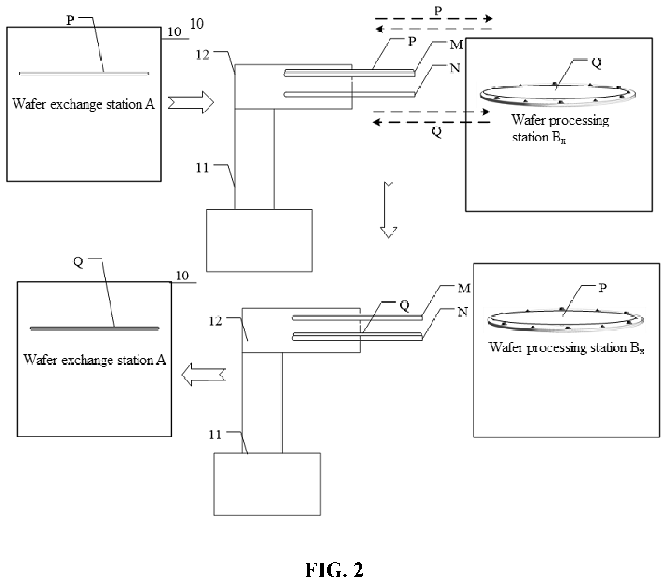

As shown in FIG. 1 and FIG. 2, the single-wafer transfer mechanism 10 mainly includes a multi-axis robot 11 and a wafer pick-and-place mechanism 12. The wafer pick-and-place mechanism 12 includes two pick-and-place clamping structures, namely M and N. The multi-axis robot 11 moves linearly or rotationally on the X, Y, and Z axes, enabling the wafer pick-and-place mechanism 12 to move between the wafer exchange station A and the wafer processing station B. When reaching the exchange station A or the wafer processing station B, the wafer pick-and-place mechanism 12 executes wafer pick-and-place operation. Both pick-and-place clamping structures M and N are capable of independently picking one wafer and placing one wafer. The two pick-and-place clamping structures M and N each have a clearly defined role. The clamping structure M is configured to pick a processed wafer from the wafer processing station B and place the processed wafer at the wafer exchange station A. The clamping structure N is configured to pick a to-be-processed wafer from the wafer exchange station A and place the to-be-processed wafer at the wafer processing station B.

A main transfer mode of the single-wafer transfer mechanism 10 is as follows. When receiving the request for picking and placing the wafer at the wafer processing station B, the wafer transfer mechanism is located at the wafer exchange station A, and the pick-and-place clamping structure M picks a to-be-processed wafer P. When the wafer transfer mechanism arrives at the wafer processing station B, another pick-and-place clamping structure N picks a processed wafer Q, and the clamping structure M carrying the to-be-processed wafer P places the to-be-processed wafer P into the wafer processing station B for processing. After placing the to-be-processed wafer P, the single-wafer transfer mechanism 10 moves to the wafer exchange station A, the wafer clamping structure M with no wafer picks a to-be-processed wafer P, and the clamping structure N carrying the processed wafer places the wafer Q into a wafer storage area. When the pick-and-place request for the wafer processing station B is received again, the above opertions are repeated to pick and place the wafer. In a case that the number of the wafer exchange station or the wafer processing station is more than one, since the single-wafer transfer mechanism 10 with a dual-clamping structure can only perform point-to-point wafer transfer, when a wafer processing station Bn (n=1, 2, 3, ...) issues a pick-and-place request, the wafer transfer mechanism 10 is already executing the wafer pick-and-place operation for another wafer processing station Bx, it is necessary to wait until the wafer pick-and-place operation for the wafer processing station Bx is completed, and then the wafer transfer mechanism 10 moves to the wafer exchange station A to pick a new to-be-processed wafer before executing the request issued by the wafer processing station Bn. As a result, the overall wafer transfer efficiency fails to keep pace with the processing efficiency.

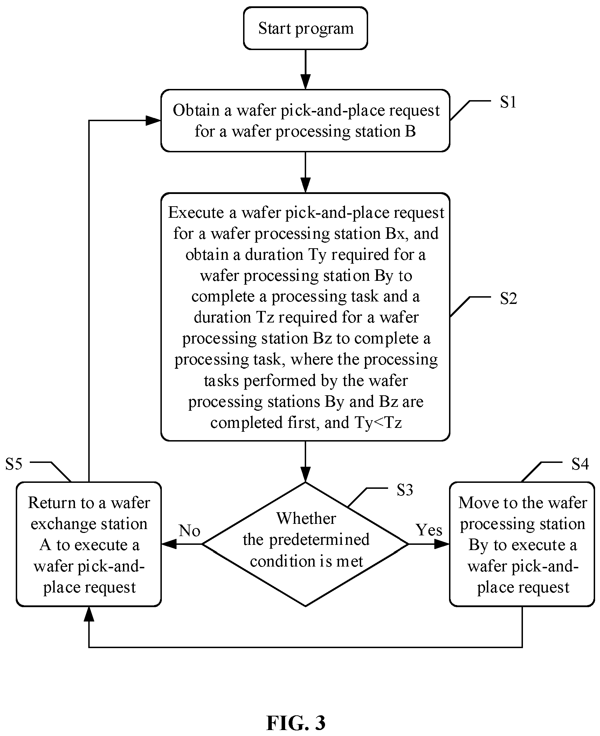

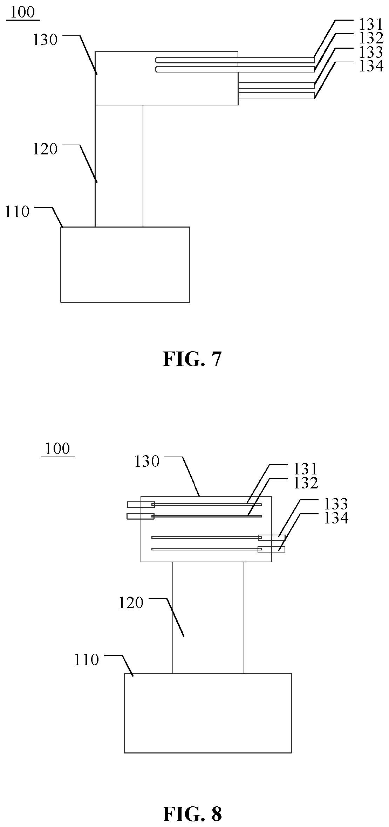

Based on the above reasons, a wafer transfer method is disclosed according to an embodiment of the present disclosure, referring to FIG. 3 and FIG. 8. In the wafer transfer method, the pick-and-place clamping structure picks two to-be-processed wafers P including a first to-be-processed wafer P1 and a second to-be-processed wafer P2, and two processed wafers Q including a first wafer Q1 and a second wafer Q2. In the embodiment of the present disclosure, the above number is only taken as an example for introduction, and other numbers of wafers may be transferred according to the wafer transfer method provided in the embodiment of the present disclosure. The wafer pick-and-place mechanism 130 includes four pick-and-place clamping structures: a first pick-and-place clamping structure 131, a second pick-and-place clamping structure 132, a third pick-and-place clamping structure 133 and a fourth pick-and-place clamping structure 134. The first pick-and-place clamping structure 131 and the third pick-and-place clamping structure 133 form a group, one for picking a wafer and the other for placing a wafer. The second pick-and-place clamping structure 132 and the fourth pick-and-place clamping structure 134 form a group, one for picking a wafer and the other for placing a wafer. The transfer method includes the following steps of S1 to S5.

In step S1, a wafer pick-and-place request for a wafer processing station B is obtained. The wafer transfer apparatus is at the wafer exchange station A. The pick-and-place clamping structure picks two to-be-processed wafers, namely a first to-be-processed wafer P1 and a second to-be-processed wafer P2. When arriving at the wafer processing station Bx, the pick-and-place clamping structure picks a first wafer Q1 that has been processed at the wafer processing station Bx, and the pick-and-place clamping structure carrying the first to-be-processed wafer P1 places the first to-be-processed wafer P1 into the wafer processing station Bx for processing.

In step S2, a wafer pick-and-place request for a wafer processing station Bx is executed, and a duration Ty required for a wafer processing station By to complete a processing task and a duration Tz required for a wafer processing station Bz to complete a processing task are obtained, where the processing tasks performed by wafer processing stations By and Bz are completed earlier than those of other stations, and Ty<Tz. The durations required for the wafer processing stations By and Bz to complete the processing, Ty and Tz (Ty<Tz), are automatically obtained, for example, by setting a timer. Alternatively, Ty and Tz may be obtained by setting a position sensor, so as to determine the route for the wafer transfer mechanism.

It should be noted that in the embodiment of the present disclosure, By and Bz are only used to indicate the two wafer processing stations that complete the processing task first. There is no special requirement for the arrangement relationship between the two wafer processing stations that complete the processing task first, and the two wafer processing stations are only determined by the duration for completing the processing task, where Ty<Tz is defined to distinguish different durations.

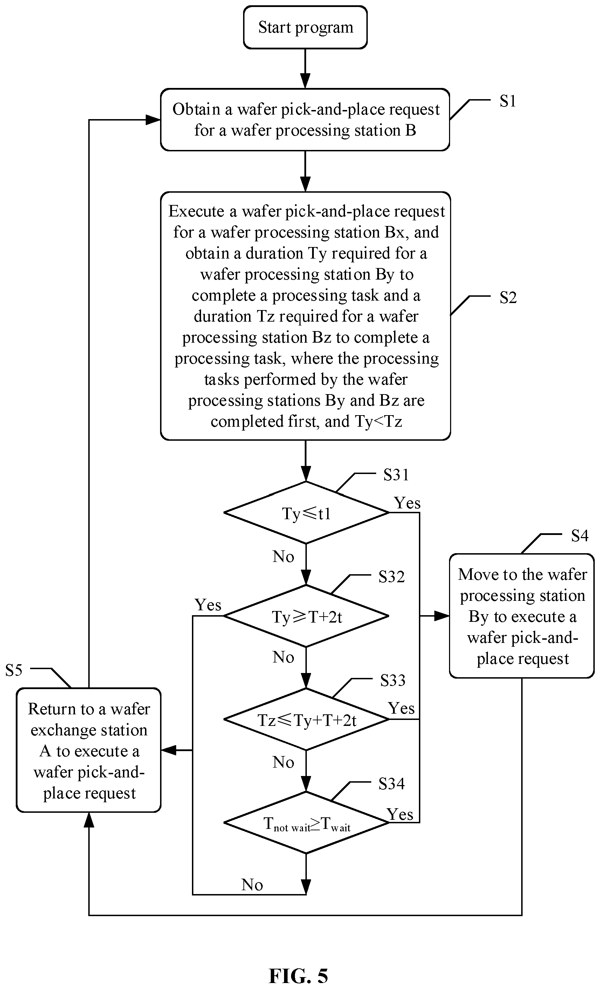

In step S3, it is determined whether the duration Ty and Tz meet a predetermined condition. In response to determining that the predetermined condition is met, step S4 is performed, that is, moving to the wafer processing station By to execute the wafer pick-and-place request. In response to determining that the predetermined condition is not met, step S5 is performed, as shown in FIG. 3 to FIG. 6.

In step S3, the predetermined condition includes: Ty≤t1, where: t1 represents a duration required for a wafer transfer apparatus to move between positions of the wafer processing station B. When there are z wafer processing stations, the duration required for the movement between all wafer processing stations is t1.

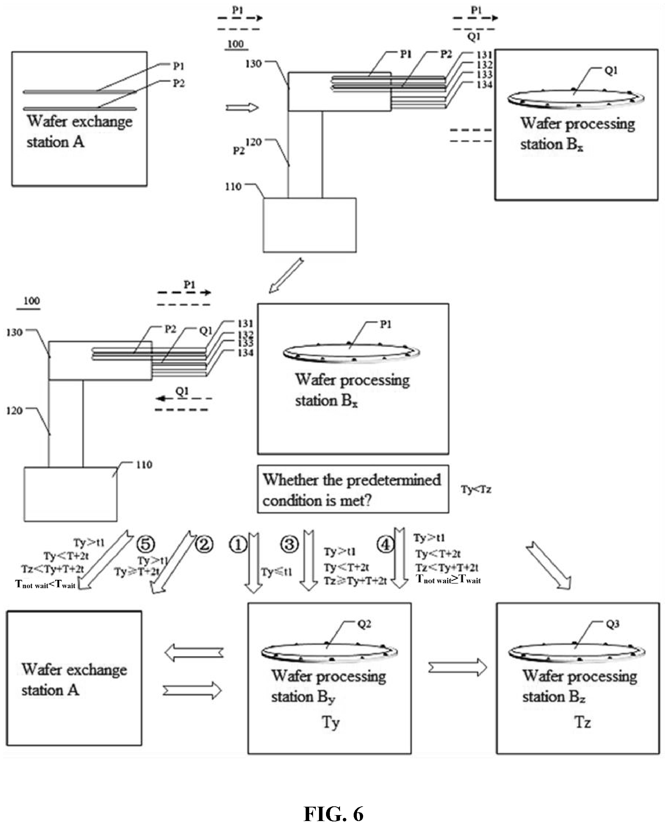

In this case, step S3 includes step S31. The condition Ty≤t1 indicates that when the wafer transfer apparatus reaches the wafer processing station By after completing the wafer pick-and-place request for the wafer processing station Bx, the processing task performed by the wafer processing station By is completed and the wafer pick-and-place request for the wafer processing station By has been issued. In the case that Ty≤t1, the wafer transfer mechanism first moves to the wafer processing station By to execute the wafer pick-and-place request, the pick-and-place clamping structure picks the wafer that has been processed by the wafer processing station By, and the pick-and-place clamping structure carrying the to-be-processed wafer places the to-be-processed wafer into the wafer processing station By for processing. Then the wafer transfer mechanism returns to the wafer exchange station A, and then moves to the wafer processing station Bz to execute the pick-and-place request. When the wafer pick-and-place request is completed, the respective durations required for two wafer processing stations to complete processing tasks first are obtained again, as shown in step ① in FIG. 6.

In step S3, the predetermined condition includes: Ty>t1 and Ty≥T+2t, where: t1 is a duration required for a wafer transfer apparatus to move between positions of the wafer processing station B; t represents a round-trip duration required for the wafer transfer apparatus to move from a wafer exchange station A to all the positions of the wafer processing station B; and T represents a duration required for the wafer transfer apparatus to execute one wafer pick-and-place operation after reaching the position.

In this case, step S3 includes S32. The condition Ty≥T+2t indicates that, when the wafer transfer apparatus reaches By after completing the wafer pick-and-place request for the wafer processing station Bx and returning to the wafer exchange station A to pick a to-be-processed wafer and place the processed wafer, the processing task performed by the wafer processing station By has not been completed. In the case that Ty≥T+2t, the wafer transfer mechanism moves to the wafer exchange station A, the pick-and-place clamping structure with no wafer picks a to-be-processed wafer, and the pick-and-place clamping structure carrying the processed wafer places the processed wafer into a wafer storage area. The wafer transfer mechanism then moves to the wafer processing station By to wait for the wafer pick-and-place request. When the wafer pick-and-place request is completed, the respective durations required for two wafer processing stations to complete the processing tasks first are obtained again, as shown in step ② in FIG. 6. Otherwise, in the case that Ty<T+2t, step S33 is performed.

In step S3, the predetermined condition includes: Ty>t1, Ty<T+2t, and Tz≥Ty+T+2t, where: t1 represents a duration required for a wafer transfer apparatus to move between positions of the wafer processing station B; t represents a round-trip duration required for the wafer transfer apparatus to move from a wafer exchange station A to all the positions of the wafer processing station B; and T represents a duration required for the wafer transfer apparatus to execute one wafer pick-and-place operation after reaching the position.

In this case, step S3 includes S33. The condition Ty≥Ty+T+2t indicates that when the wafer transfer apparatus reaches Bz after completing the wafer pick-and-place request for the wafer processing station By and returning to the wafer exchange station A to pick a to-be-processed wafer and place the processed wafer, the processing task performed by the wafer processing station Bz has not been completed. In the case that Ty≥Ty+T+2t, in order to reduce the number of movements of the wafer transfer mechanism, the wafer transfer mechanism first moves to the wafer processing station By to execute the wafer pick-and-place request; the pick-and-place clamping structure picks the wafer that has been processed at the wafer processing station By, and the pick-and-place clamping structure carrying the to-be-processed wafer places the to-be-processed wafer into the wafer processing station By for processing. Then the wafer transfer mechanism returns to the wafer exchange station A, and then moves to the wafer processing station Bz to execute the pick-and-place request. When the wafer pick-and-place request is completed, the respective durations required for two wafer processing stations to complete processing tasks first are obtained again, as shown in step ③ in FIG. 6. Otherwise, step S34 is performed.

In step S3, the predetermined condition includes: Ty>t1, Ty<T+2t, Tz<Ty+T+2t, and T_{not wait}≥T_{wait}, where: t1 represents a duration required for a wafer transfer apparatus to move between positions of the wafer processing station B; t represents a round-trip duration required for the wafer transfer apparatus to move from a wafer exchange station A to all the positions of the wafer processing station B; T_{not wait} represents a processing waiting time when the wafer transfer apparatus does not wait for a wafer pick-and-place request for the wafer processing station By, T_{not wait} =T+2t-Ty; T_{wait} represents a processing waiting time when the wafer transfer apparatus waits for a wafer pick-and-place request for the wafer processing station By, T_{wait}=Ty+2T+2t-Tz; and T represents a duration required for the wafer transfer apparatus to execute one wafer pick-and-place operation after reaching the position, as shown in step ④ in FIG. 6.

Step S3 further includes step S34. T_{not wait}≥T_{wait} indicates that the processing costs more time when the wafer transfer apparatus first returns to the wafer exchange station A and then executes the wafer pick-and-place request for the wafer processing station By. In the case that T_{not wait}≥T_{wait}, the wafer transfer apparatus first moves to the wafer processing station By to perform wafer pick-and-place operation, and then returns to the wafer exchange station A. Otherwise, step S5 is performed, that is, the wafer transfer apparatus first returns to the wafer exchange station A to perform wafer pick-and-place operation, as shown in step ⑤ in FIG. 6.

In the case of not waiting for the wafer pick-and-place request for the wafer processing station By, the wafer transfer apparatus returns to the wafer exchange station A first, and then moves to the wafer processing station By. When the wafer transfer apparatus arrives at the wafer processing station By, the processing task performed by the wafer processing station By has been completed and the wafer pick-and-place request is to be executed. The processing waiting time is expressed as T_{not wait} =T+2t-Ty.

In the case of waiting for the wafer pick-and-place request for the wafer processing station By, the wafer transfer apparatus first moves to the wafer processing station By to pick and place the wafer at the wafer processing station By. However, since the wafer pick-and-place requests for the wafer processing stations Bx and By are executed continuously, the pick-and-place clamping structures of the wafer transfer mechanism are in a full load state, and the wafer transfer apparatus should return to the wafer exchange station A to replenish to-be-processed wafers and store the processed wafers. In this case, the processing task of the wafer processing station Bz has been completed, and the wafer pick-and-place request is to be executed. The processing waiting time is expressed as T_{wait}=Ty+2T+2t-Tz.

In step S4, move to the wafer processing station By first to execute a wafer pick-and-place request.

In step S5, return to a wafer exchange station A first to execute a wafer pick-and-place request.

In the wafer transfer method according to the present disclosure, the required duration of the wafer processing station and the round-trip duration of the wafer transfer mechanism are calculated, and subsequent wafer pick-and-place operations are executed based on the calculation, so that route planning in advance is realized. The wafer transfer method is applicable to wafer transfer in one-to-multiple mode and multiple-to-multiple mode, ensuring that more wafer transfer requests can be processed per unit time and improving the wafer transfer efficiency.

With the improvement of the wafer transfer structure and the unique wafer transfer method, more wafer transfer requests may be executed. This technical solution is applicable to various wafer processing fields, and conventional wafer transfer mechanism may be replaced.

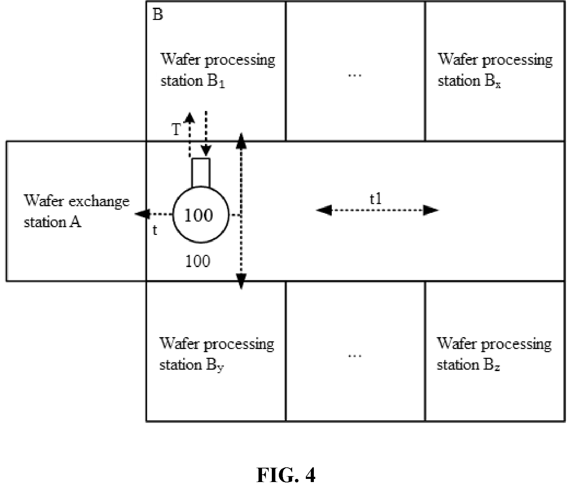

A wafer transfer apparatus is further disclosed in an embodiment of the present disclosure, as shown in FIG. 4 and FIG. 6. The wafer transfer apparatus is configured to move according to the wafer transfer method mentioned above. The wafer transfer apparatus 100 includes a wafer transfer mechanism 110, a multi-axis robot 120 and a wafer pick-and-place mechanism 130. The wafer transfer mechanism 110 is configured to move between a wafer exchange station and multiple wafer processing stations. The multi-axis robot 120 is arranged on the wafer transfer mechanism 110 to regulate a pick-and-place angle of the wafer pick-and-place mechanism 130. The wafer pick-and-place mechanism 130 is arranged on the multi-axis robot 120 to execute wafer pick-and-place operation.

In response to determining that the predetermined condition is met, step S4 is performed, that is, the wafer pick-and-place request is executed at the wafer processing station By first. In this case, the wafer transfer mechanism 110 drives the wafer transfer apparatus 100 to move to the wafer processing station By. Otherwise, step S5 is performed, that is, the wafer pick-and-place request is executed at the wafer exchange station A. In this case, the wafer transfer mechanism 110 drives the wafer transfer apparatus 100 to move to the wafer exchange station A.

In order to improve the pick-and-place efficiency of the wafer pick-and-place mechanism 130, in some embodiments of the present disclosure, the wafer pick-and-place mechanism 130 includes multiple pick-and-place clamping structures, and the multiple pick-and-place clamping structures are arranged one above another. Alternatively, the wafer transfer apparatus 100 is provided with a wafer storage structure for storing the to-be-processed wafers picked from the wafer exchange station. The wafer pick-and-place mechanism 130 includes four pick-and-place clamping structures: a first pick-and-place clamping structure 131, a second pick-and-place clamping structure 132, a third pick-and-place clamping structure 133 and a fourth pick-and-place clamping structure 134. The first pick-and-place clamping structure 131 and the third pick-and-place clamping structure 133 form a group, one for picking a wafer and the other for placing a wafer. The second pick-and-place clamping structure 132 and the fourth pick-and-place clamping structure 134 form a group, one for picking a wafer and the other for placing a wafer.

In the above, the terms "first", "second" and the like are only for purpose of description, and should not be interpreted as indicating or implying relative importance or implying the number of the indicated technical features. Therefore, the features defined by "first" and "second" may explicitly or implicitly include one or more of the features.

A wafer transfer system is further disclosed in the present disclosure. The wafer transfer system includes a wafer exchange station, multiple wafer processing stations, the wafer transfer apparatus as described above, and a controller. The controller performs the following steps:
obtaining a wafer pick-and-place request for a wafer processing station B;
executing a wafer pick-and-place request for a wafer processing station Bx, and obtaining a duration Ty required for a wafer processing station By to complete a processing task and a duration Tz required for a wafer processing station Bz to complete a processing task, where the processing task performed by the wafer processing station By and the processing task performed by the wafer processing station Bz are completed first, and Ty<Tz; and
determining whether Ty and Tz meet a predetermined condition; in response to determining that the predetermined condition is met, moving to the wafer processing station By to execute the wafer pick-and-place request; and in response to determining that the predetermined condition is not met, returning to a wafer exchange station A to execute a wafer pick-and-place request.

The controller described above includes a processor and a memory. The memory stores an operating program. The processor executes the above steps according to the operating program stored in the memory. The controller described above may be integrated on a wafer transfer apparatus. Alternatively, the controller may be implemented as a mobile terminal, such as a mobile phone, a laptop, a palmtop, a desktop computer, or the like, to coordinate control.

It should be noted that, to facilitate description, only parts related to the present disclosure are shown in the drawings. The embodiments of the present disclosure and the features in the embodiments may be combined with each other in the case of no conflict.

The above description only illustrates preferable embodiments of the present disclosure and the technical principles applied, which are not intended to limit the present disclosure. For those skilled in the art, the present disclosure may be changed and varied variously. The scope of the present disclosure is not limited to the technical solutions formed by a particular combination of the above technical features, but also covers other technical solutions formed by any combination of the above technical features or their equivalent features without departing from the above application concept. For example, the scope of the present disclosure may cover a technical solution formed by replacing the features described above with technical features with similar functions disclosed in (but not limited to) the present disclosure.

## Claims

1. A wafer transfer method, comprising the following steps:
obtaining a wafer pick-and-place request for a wafer processing station B;
executing a wafer pick-and-place request for a wafer processing station Bx, and obtaining a duration Ty required for a wafer processing station By to complete a processing task and a duration Tz required for a wafer processing station Bz to complete a processing task, wherein the processing task performed by the wafer processing station By and the processing task performed by the wafer processing station Bz are completed first, and Ty<Tz;
determining whether Ty, Tz and a wafer transfer duration meet a predetermined condition;
in response to determining that the predetermined condition is met, moving to the wafer processing station By to execute a wafer pick-and-place request; and
in response to determining that the predetermined condition is not met, returning to a wafer exchange station A to execute a wafer pick-and-place request.

2. The wafer transfer method according to claim 1, wherein the predetermined condition comprises: Ty≤t1, and
t1 represents a duration required for a wafer transfer apparatus to move between positions of the wafer processing station B.

3. The wafer transfer method according to claim 1, wherein the predetermined condition comprises: Ty>t1, and Ty≥T+2t, wherein
t1 represents a duration required for a wafer transfer apparatus to move between positions of the wafer processing station B;
t represents a round-trip duration required for the wafer transfer apparatus to move from the wafer exchange station A to all the positions of the wafer processing station B; and
T represents a duration required for the wafer transfer apparatus to execute one wafer pick-and-place operation after reaching a position.

4. The wafer transfer method according to claim 1, wherein the predetermined condition comprises: Ty>t1, Ty<T+2t, and Tz≥Ty+T+2t, wherein
t1 represents a duration required for a wafer transfer apparatus to move between positions of the wafer processing station B;
t represents a round-trip duration required for the wafer transfer apparatus to move from the wafer exchange station A to all the positions of the wafer processing station B; and
T represents a duration required for the wafer transfer apparatus to execute one wafer pick-and-place operation after reaching a position.

5. The wafer transfer method according to claim 1, wherein the predetermined condition comprises: Ty>t1, Ty<T+2t, Tz<Ty+T+2t, and T_{not wait} ≥T_{wait} , wherein
t1 represents a duration required for a wafer transfer apparatus to move between positions of the wafer processing station B;
t represents a round-trip duration required for the wafer transfer apparatus to move from a wafer exchange station A to all the positions of the wafer processing station B;
T represents a duration required for the wafer transfer apparatus to execute one wafer pick-and-place operation after reaching a position;
T_{not wait} represents a processing waiting time when the wafer pick-and-place request for the wafer processing station By is not waited, T_{not wait} =T+2t-Ty; and
T_{wait} represents a processing waiting time when the wafer pick-and-place request for the wafer processing station By is waited, and T_{wait}=Ty+2T+2t-Tz.

6. A wafer transfer apparatus, configured to move according to the wafer transfer method according to any one of claims 1 to 5, wherein the wafer transfer apparatus comprises:
a wafer transfer mechanism;
a multi-axis robot; and
a wafer pick-and-place mechanism, wherein
the wafer transfer mechanism is configured to move between a wafer exchange station and a plurality of wafer processing stations;
the multi-axis robot is arranged on the wafer transfer mechanism to regulate a pick-and-place angle of the wafer pick-and-place mechanism; and
the wafer pick-and-place mechanism is arranged on the multi-axis robot to execute wafer pick-and-place.

7. The wafer transfer apparatus according to claim 6, wherein the wafer pick-and-place mechanism comprises a plurality of pick-and-place clamping structures, and the plurality of the pick-and-place clamping structures are arranged one above another.

8. The wafer transfer apparatus according to claim 7, wherein the wafer pick-and-place mechanism comprises four pick-and-place clamping structures: a first pick-and-place clamping structure, a second pick-and-place clamping structure, a third pick-and-place clamping structure and a fourth pick-and-place clamping structure, wherein the first pick-and-place clamping structure and the third pick-and-place clamping structure form a group, one for picking a wafer and the other for placing a wafer; and the second pick-and-place clamping structure and the fourth pick-and-place clamping structure form a group, one for picking a wafer and the other for placing a wafer.

9. A wafer transfer system, comprising:
a wafer exchange station;
a plurality of wafer processing stations;
the wafer transfer apparatus according to any one of claims 6 to 8; and
a controller, wherein the controller performs the following steps:
obtaining a wafer pick-and-place request for a wafer processing station B;
executing a wafer pick-and-place request for a wafer processing station Bx, and obtaining a duration Ty required for a wafer processing station By to complete a processing task and a duration Tz required for a wafer processing station Bz to complete a processing task, wherein the processing task performed by the wafer processing station By and the processing task performed by the wafer processing station Bz are completed first, and Ty<Tz;
determining whether the durations Ty and Tz meet a predetermined condition;
in response to determining that the predetermined condition is met, moving to the wafer processing station By to execute a wafer pick-and-place request; and
in response to determining that the predetermined condition is not met, returning to a wafer exchange station A to execute a wafer pick-and-place request.

10. The wafer transfer system according to claim 9, wherein the controller is integrated on the wafer transfer apparatus.
